# DEMANDE DE BREVET EUROPEEN

(11) **EP 1 852 912 A1**
(43) Date de publication de la demande: **07.11.2007**
(21) Numéro de dépôt: 07290553.2
(22) Date de dépôt: 02.05.2007
(51) Int. Cl.: H01L 25/07, H01L 23/48

(54) **Dispositif et procédé de centrage d'un élément à semi-conducteur destiné à être inséré dans un ensemble à empilement pressé et ensemble à empilement pressé comportant un tel dispositif**

(30) Priorité: 04.05.2006 FR 0604017
(71) Demandeur: Converteam SAS, 91300 Massy (FR)
(72) Inventeur: Bele, Joris, 75012 Paris (FR)
(74) Mandataire: Habasque, Etienne J. Jean-François

(57) **Abrégé**

L'invention concerne un dispositif à semi-conducteur destiné à être monté dans un ensemble à empilement pressé, ledit dispositif comportant un élément à semi-conducteur sous forme de galette (40) ayant un axe longitudinal central, une pièce (46) de positionnement de l'élément à semi-conducteur comprenant un espace (62) transversal de réception de celui-ci, des moyens (64,76,86) de maintien de l'élément à semi-conducteur dans cet espace (62), et une portion de positionnement (72) de la pièce (46) dans l'ensemble à empilement pressé.
Ce dispositif comprend des moyens réglables (86) de positionnement et d'immobilisation transversale de l'élément à semi-conducteur (40) dans l'espace (62) de réception.

## Description

La présente invention concerne un dispositif à semi-conducteur destiné à être monté dans un ensemble à empilement pressé, et plus particulièrement un tel dispositif comportant :
- un élément à semi-conducteur sous forme de galette ayant un axe longitudinal central ;
- une pièce de positionnement de l'élément à semi-conducteur comprenant un espace transversal de réception de celui-ci, des moyens de maintien de l'élément à semi-conducteur dans cet espace, et une portion de positionnement de la pièce dans l'ensemble à empilement pressé ; et
- des moyens de positionnement et d'immobilisation transversale de l'élément à semi-conducteur dans l'espace de réception.

Un tel dispositif est connu par le document US-A-4404582.

Un module de puissance, comme par exemple celui destiné à fournir de l'énergie électrique à un convertisseur pour moteur de puissance supérieure au mégawatt, comprend des éléments empilés et comprimés sous une pression de plusieurs tonnes selon un axe d'empilement longitudinal. Ces ensembles, communément désignés sous le nom d'ensembles « press-pack », sont pressés au moyen de deux brides latérales externes solidarisées par deux tirants longitudinaux parallèles à l'axe d'empilement. Un tel module de puissance est communément désigné sous le nom de « pile ».

Une pile comporte généralement un ou plusieurs éléments à semi-conducteur (ci-après désignés par « semi-conducteurs ») de puissance, chacun sous la forme d'une galette cylindrique comportant deux surfaces planes transversales circulaires parallèles opposées, comme par exemple une diode, un thyristor ou un transistor de puissance, et des circuits de refroidissement agencés de part et d'autre de chaque semi-conducteur. Chacun de ces circuits de refroidissement comportant également une surface transversale d'échange thermique plane circulaire en contact avec la surface plane correspondante du semi-conducteur.

Pour un fonctionnement satisfaisant de l'ensemble press-pack, un alignement central minimal du semi-conducteur avec ses circuits de refroidissement associés est requis.

Une sucette classique de centrage d'une diode ou d'un thyristor de puissance pour l'extraction et le montage facilités d'un semi-conducteur press-pack dans une pile est formée d'une plaque de matière plastique usinée comportant un évidement circulaire dans lequel est encliqueté(e) la diode ou le thyristor. Cette sucette comporte par ailleurs une poignée et deux languettes de positionnement aptes à recevoir chacune un des tirants de la pile pour le centrage de la sucette par rapport à l'axe d'empilement de celle-ci.

Pour pouvoir fonctionner de manière satisfaisante, des semi-conducteurs à grandes surfaces, comme les transistors IEGT (acronyme anglais de « Injected Enhenced Gate Transistor »), nécessitent un centrage d'une précision inférieure à 0,5 mm avec leurs circuits de refroidissement respectifs.

Or, le principe de centrage avec une sucette décrite précédemment consiste à encliqueter un semi-conducteur dans l'évidement de la sucette, puis à positionner cet évidement par rapport à l'axe d'empilement de la pile au moyen des languettes de positionnement. Le semi-conducteur est donc positionné globalement. Une telle sucette réalise en moyenne un centrage de l'ordre d'un à deux millimètres avec l'axe d'empilement de la pile, ce qui est insuffisant pour les semi-conducteurs à grandes surfaces.

Le but de la présente invention est de résoudre le problème susmentionné en proposant un dispositif permettant le centrage d'un semi-conducteur avec grande précision sur l'axe d'empilement d'un ensemble press-pack.

A cet effet, l'invention a pour objet un dispositif à semi-conducteur destiné à être monté dans un ensemble à empilement pressé, comportant :
- un élément à semi-conducteur sous forme de galette ayant un axe longitudinal central ;
- une pièce de positionnement de l'élément à semi-conducteur comprenant un espace transversal de réception de celui-ci, des moyens de maintien de l'élément à semi-conducteur dans cet espace, et une portion de positionnement de la pièce dans l'ensemble à empilement pressé ; et
- des moyens de positionnement et d'immobilisation transversale de l'élément à semi-conducteur dans l'espace de réception,
lesdits moyens de positionnement et d'immobilisation transversale étant réglables.

Selon d'autres caractéristiques :
- les moyens réglable de positionnement et d'immobilisation sont aptes à positionner l'axe longitudinal central de l'élément à semi-conducteur sur un axe de la pièce sensiblement confondu avec l'axe d'empilement de l'ensemble à empilement pressé lorsque l'élément à semi-conducteur est monté dans celui-ci ;
- les moyens réglable de positionnement et d'immobilisation comportent des vis de réglage de la position transversale de l'élément à semi-conducteur dans l'espace de ladite pièce ;
- les moyens de maintien comprennent des moyens d'immobilisation longitudinale de l'élément à semi-conducteur dans l'espace de réception ;
- les moyens d'immobilisation longitudinale comprennent une bride apte à plaquer une collerette périphérique de l'élément à semi-conducteur sur une surface transversale de la pièce de positionnement ; et
- la pièce de positionnement comporte une poignée;
- la portion de positionnement de la pièce dans l'ensemble à empilement pressé comprend au moins un arceau aptes à loger un tirant de l'ensemble à empilement pressé ; et
- ladite pièce est constituée d'une résine.

L'invention a également pour objet un ensemble à empilement pressé comportant un ensemble de dispositifs à semi-conducteur pressés selon un axe d'empilement longitudinal, au moins un de ces dispositifs étant amovible et comportant
- un élément à semi-conducteur sous forme de galette ayant un axe longitudinal central ; et
- une pièce de positionnement de l'élément à semi-conducteur comprenant un espace transversal de réception de celui-ci, des moyens de maintien de l'élément à semi-conducteur dans cet espace, et une portion de positionnement de la pièce dans l'ensemble à empilement pressé,
caractérisé en ce que cet au moins un dispositif amovible comprend des moyens réglables de positionnement et d'immobilisation transversale de l'axe longitudinal central de l'élément à semi-conducteur sur un axe de la pièce sensiblement confondu avec l'axe d'empilement.

L'invention a également pour objet un procédé de centrage d'un axe longitudinal central d'un élément à semi-conducteur sous forme de galette sur un axe d'empilement longitudinal d'un ensemble à empilement pressé, caractérisé en ce qu'il comprend les étapes consistant à :
- mettre en place une pièce pourvue d'un espace de réception de l'élément à semi-conducteur sur un gabarit de centrage muni d'un organe de positionnement de l'axe central de l'élément à semi-conducteur sur un axe prédéterminé du gabarit ;
- positionner l'élément à semi-conducteur dans l'espace de réception de la pièce en positionnant l'axe central de l'élément à semi-conducteur sensiblement sur l'axe prédéterminé du gabarit à l'aide de l'organe de positionnement ;
- solidariser l'élément à semi-conducteur avec la pièce ; et
- retirer l'ensemble solidarisé formé de l'élément à semi-conducteur et de la pièce de support du gabarit.

Suivant une variante, il comporte en outre une étape de montage de l'ensemble solidarisé dans l'ensemble à empilement pressé.

L'invention sera mieux comprise à la lecture de la description qui va suivre, donnée uniquement à titre d'exemple, et faite en relation avec les dessins annexés, dans lesquels des références identiques désignent des éléments identiques ou analogues, et dans lesquels :
- la figure 1 est une vue en perspective d'un module de puissance comprenant un empilement d'ensembles press-pack comportant des dispositifs selon l'invention ;
- la figure 2 est une vue de face du module de puissance de la figure 1 ;
- la figure 3 est une vue en perspective d'un dispositif selon l'invention entrant dans la constitution du module des figures 1 et 2 ; et
- la figure 4 est une vue en perspective d'une pièce du dispositif de la figure 3 ; et
- la figure 5 est une vue en perspective d'un gabarit de centrage selon l'invention.

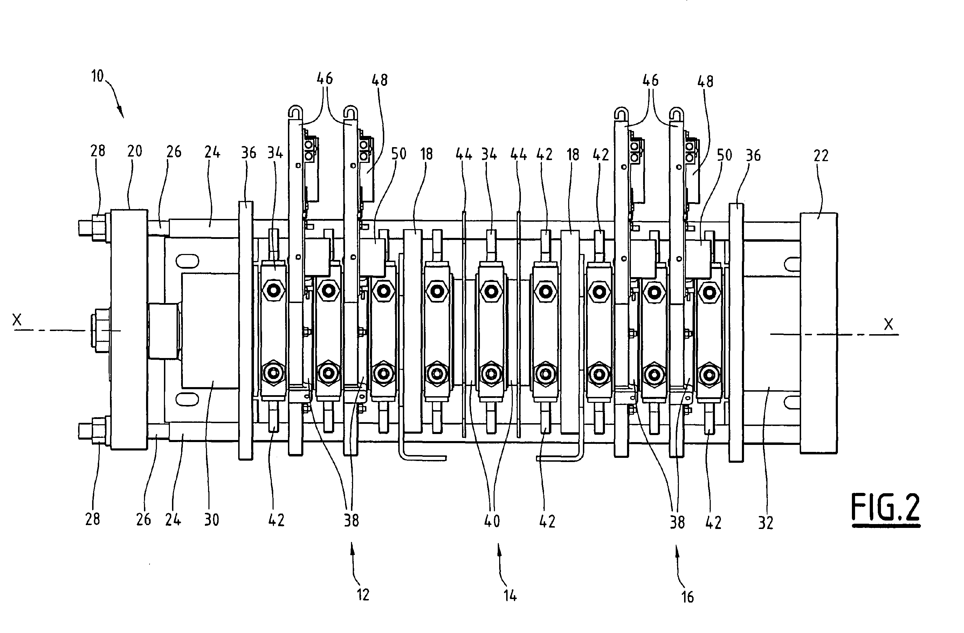

Dans ce qui suit, le terme « longitudinal » se rapportera à des droites et plans parallèles à l'axe d'empilement X-X illustré à la figure 2, et le terme « transversal » se rapportera à des droites et plans orthogonaux à l'axe d'empilement X-X.

Sur les dessins, les proportions des objets représentés sont conformes à la réalité.

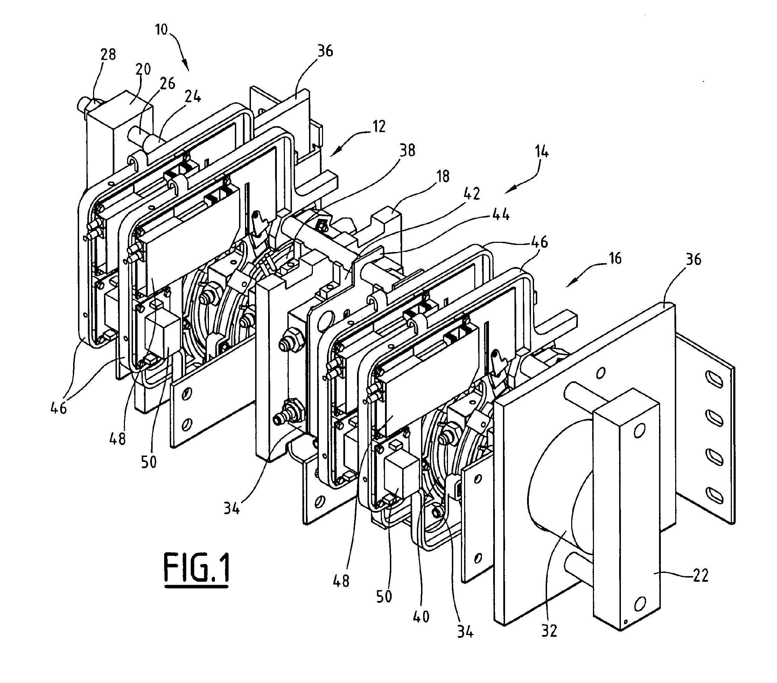

Sur les figures 1 et 2, il est représenté une pile à IEGT 10 destinée à fournir de l'énergie électrique à un convertisseur de moteur d'une puissance supérieure au mégawatt.

La pile 10 comporte six ensembles press-pack 12, 14, 16 séparés par des plaques transversales 18 isolantes. Ces ensembles press-pack 12, 14, 16 sont empilés selon un axe longitudinal X-X sous une pression de plusieurs tonnes exercée par un système de mise en pression. Ce système comporte deux brides de serrage 20, 22 agencées de part et d'autre des ensembles press-pack et fixées l'une à l'autre par deux tirants cylindriques longitudinaux 24 parallèles à l'axe d'empilement X-X et à égale distance de celui-ci.

Chaque tirant longitudinal 24 comporte une extrémité encastrée dans l'une des brides de serrage 22 et l'autre de ses extrémités comporte un filetage 46 s'engageant dans un trou traversant correspondant formé dans l'autre bride 22 de serrage, et sur lequel vient se visser un boulon 28.

Le système de mise en pression comprend enfin un organe 30, 32 de répartition homogène de pression agencé entre chaque bride de serrage 20, 22 et une surface longitudinale d'un circuit de refroidissement 34 agencé au début ou à la fin de la pile 10. Ces organes 30, 32 de répartition de pression ont pour effet de transférer de façon homogène la pression exercée par les brides de serrage 20, 22, au moyen du vissage des boulons 28 sur les filets 26 des tirants 24, aux surfaces des circuits de refroidissement 34 avec lesquelles ils sont en contact.

Enfin, la pile 10 comporte des équerres de support 36 traversées par les tirants 24 et les organes 30, 32 de répartition de pression et permettant de fixer la pile 10 à un bâti (non représenté).

Un ensemble press-pack 12, 14, 16 comporte un empilement selon l'axe X-X de deux semi-conducteurs 38, 40, et plus particulièrement des diodes de puissance 38 ou des transistors IEGT de puissance 40, et de circuits de refroidissement 34 connectés à un système de circulation d'eau (non représenté), chaque semi-conducteur 38, 40 étant interposé entre deux circuits de refroidissement 34.

Comme cela est connu en soi, un semi-conducteur 38, 40 présente la forme d'une galette cylindrique, un transistor IEGT étant en outre pourvu d'une collerette circulaire transversale périphérique.

Chaque semi-conducteur 38, 40 et chaque circuit de refroidissement 34 d'un ensemble press-pack 12, 14, 16 comporte des surfaces avant et arrière transversales circulaires et concentriques, ces surfaces de l'élément étant en contact avec des surfaces transversales circulaires correspondantes d'éléments qui lui sont adjacents.

On désignera par la suite par axe « central », l'axe longitudinal d'un élément, passant par les centres des surfaces circulaires de celui-ci. Par centrage, on entendra par la suite l'alignement de l'axe central d'un élément des ensembles press-pack avec l'axe d'empilement X-X.

Chaque circuit de refroidissement 34 comporte deux arceaux latéraux opposés 42 dans lesquels sont respectivement engagés les tirants longitudinaux 24 de sorte que le circuit de refroidissement 34 est sensiblement centré sur l'axe d'empilement X-X.

Les circuits de refroidissement 34 étant des éléments présentant un taux de défaillance faible, ils restent à demeure dans la pile 10. Leur centrage sur l'axe X-X est donc réalisé avec précision lors de la fabrication de la pile 10.

Les diodes 38 et les transistors IEGT 40 étant plus fragiles, ils nécessitent d'être régulièrement remplacés.

L'extraction d'une diode défectueuse, le positionnement et le centrage d'une nouvelle diode de remplacement sont réalisés à l'aide de sucettes de centrage/extraction 44 classiques associées aux diodes 38. Une telle sucette 44 garantit le centrage d'une diode 38 avec une précision d'un à deux millimètres, ce qui s'avère suffisant pour un fonctionnement satisfaisant de celle-ci.

Le remplacement d'un transistor IEGT défectueux, le positionnement et le centrage d'un nouveau transistor IEGT de remplacement sont quant à eux réalisés à l'aide de sucettes d'extraction/centrage 46 selon l'invention associées à chaque transistor IEGT 40. Une telle sucette 46 permet un centrage plus précis du transistor IEGT qui lui est associé.

Par ailleurs, une sucette 46 selon l'invention comporte également des logements pour la réception d'un organe 48 de pilotage, ou driver, et d'un boîtier d'alimentation 50 du transistor IEGT 40.

Un transistor IEGT 40 forme, avec sa sucette d'extraction/centrage 46, son driver 48 et son boîtier d'alimentation 50, un ensemble, ou macro-composant IEGT, de faible encombrement, avec des connexions électriques courtes et protégeant le transistor IEGT 40 de dépôt d'électricité statique sur ses surfaces. Ce macro-composant et la sucette 46 selon l'invention seront expliqués plus en détail par la suite.

Il est à noter qu'aucun système de centrage utilisant des goupilles de centrage n'est ainsi nécessaire pour centrer les divers semi-conducteurs 38, 40 de la pile 10 sur l'axe X-X.

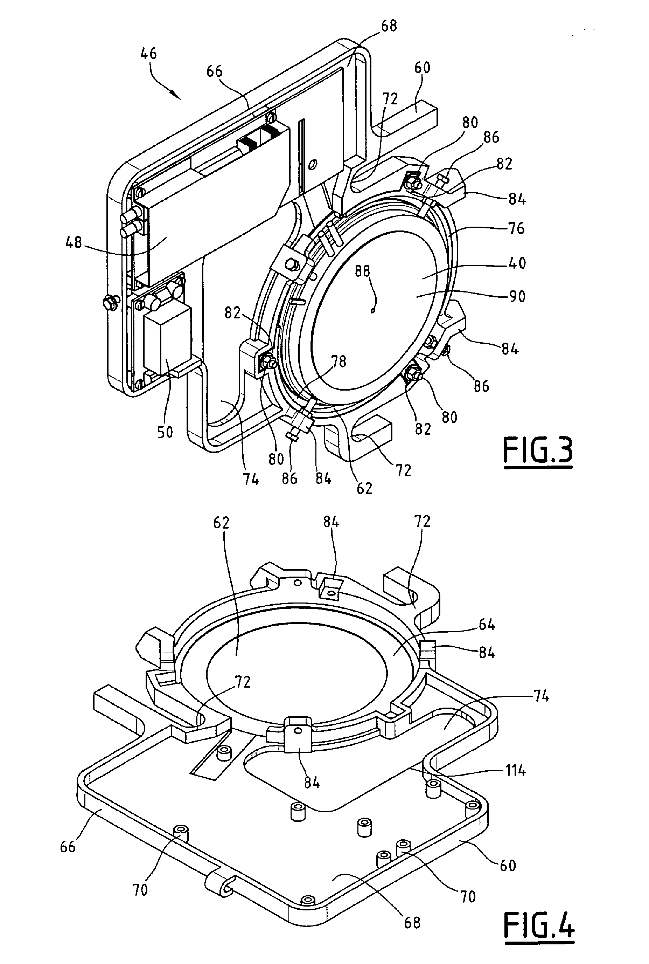

Il va maintenant être décrit en relation avec les figures 3 et 4 un macro-composant IEGT et une sucette d'extraction/centrage 40 selon l'invention.

La sucette 46 comporte une plaque 60 moulée par injection en une résine isolante. Cette plaque 60 est pourvue d'un espace transversal 62 ouvert circulaire de diamètre supérieur à celui du transistor 40 et dans lequel vient se loger ce dernier. L'espace 62 est partiellement fermé sur l'un de ses cotés transversaux par une collerette 64 définissant une ouverture circulaire de diamètre inférieur à celui du transistor 40.

La plaque 60 comprend également un rebord transversal en saillie 66 sur une surface transversale 68 duquel sont prévus des plots cylindriques 70 creux pourvus de filets internes pour la réception et la fixation par vissage du driver 48 et du boîtier d'alimentation 50.

La plaque 60 comporte également deux arceaux latéraux 72 dans lesquels se logent les tirants 24 lorsque la sucette 46 associée à son transistor IEGT 40 sont montés dans la pile 10. Une poignée 74 est par ailleurs formée dans la plaque 60 au moyen d'un évidement dans le rebord en saillie 66.

La sucette 46 comporte également une bride circulaire amovible 76 moulée par injection dans le même matériau que la plaque 60. La bride 76 presse la collerette circulaire transversale périphérique 78 du transistor IEGT 40 sur la collerette 64 de la pièce 60, ceci étant réalisé au moyen d'un système 80 à vis et écrous solidarisant des languettes périphériques 82 de la bride circulaire 76 avec sur une surface transversale de la plaque 60. Le transistor IEGT 40 est ainsi immobilisé longitudinalement dans l'espace 62.

La plaque 60 comprend par ailleurs trois portions longitudinales 84 pourvues de trous dans lesquels sont respectivement insérés trois ensembles de vis et d'écrou 86. Les vis de ensembles 86 sont suffisamment longues pour venir au contact de la tranche du transistor IEGT 40 de sorte qu'il est possible en les vissant et dévissant de régler et bloquer la position transversale les centres 88 des surfaces avant et arrière 90 du transistor IEGT dans l'espace 62 de la pièce 60.

Selon l'invention, l'axe central du transistor IEGT 40 est pré-positionné dans l'espace 62 sur un axe longitudinal de la sucette 46 que l'on sait être confondu, avec une précision inférieure à 0,5 millimètres et de préférence avec une précision de 0,1 à 0,2 millimètres, avec l'axe d'empilement X-X de la pile 10 une fois l'ensemble sucette/transistor monté dans celle-ci.

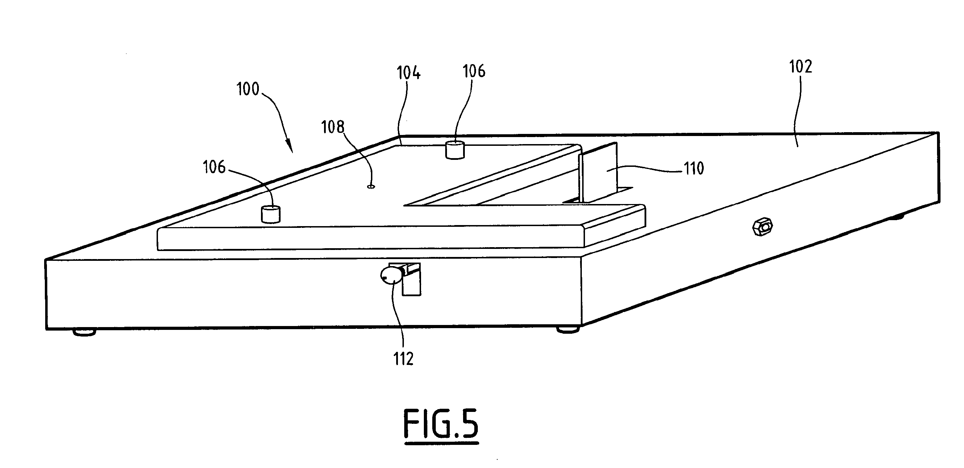

Par exemple, il est possible pour cela d'utiliser un gabarit de centrage 100 tel qu'illustré à la figure 5. L'utilisation du gabarit 100 pour le positionnement du transistor IEGT 40 dans l'espace 62 de la sucette se fonde sur la caractéristique selon laquelle un transistor IEGT comprend généralement un trou sur chacune de leur surface longitudinale, ces trous étant agencés au niveau de l'axe central du transistor.

Le gabarit de centrage 100 comporte un bâti plan 102 sur lequel est fixée une plaque de centrage 104 comportant deux plots cylindriques 106, de même diamètre que celui des tirants 24 de la pile 10 et espacés de la même distance que ceux-ci.

La plaque 104 est également pourvue d'un trou cylindrique 108 agencé entre les deux plots 106 au niveau d'un axe du gabarit 100 correspondant à l'axe d'empilement X-X de la pile 10, et de diamètre égal à celui des trous centraux du transistor IEGT.

Enfin, le gabarit de centrage 100 comporte une lame de calage 110 rétractable dans le bâti 102 et manoeuvrable par un levier 112 par des moyens appropriés (non représentés).

Les dimensions, la forme et l'agencement de la plaque de centrage 104 et de la lame de calage 110 sont choisis par que la plaque 60 de la sucette 46 puisse reposer à plat sur la plaque 104 avec les plots 102 engagés dans les arceaux 72, et avec une surface interne 114 de la poignée 74 calée contre la lame 110 pour que la plaque 60 soit immobilisée sur le gabarit 100 dans une position correspondante à celle qu'elle aurait si elle était montée sur la pile 10.

Le montage du transistor 40 dans la sucette 46 est alors le suivant.

La plaque 60 est montée sur le gabarit 100 en logeant les plots 106 dans les arceaux 72 de celle-ci.

Une goupille est alors insérée partiellement dans le trou 108 de la plaque de centrage 104 de sorte qu'une portion de celle-ci fait saillie de la plaque 104.

Le transistor IEGT 40 est ensuite logé dans l'espace 62 de la plaque 60 avec la portion en saillie de la goupille engagée dans le trou central correspondant du transistor IEGT 40.

La bride amovible 76 est ensuite vissée sur la plaque 60 pour immobiliser longitudinalement le transistor 40 dans l'espace 62.

Le transistor 40 est alors immobilisé transversalement dans l'espace 62 au moyen des ensembles de vis/boulons 86. L'axe central du transistor 40 est ainsi positionné sur un axe longitudinal de la plaque 60 sensiblement confondu avec l'axe X-X lorsque le transistor est monté dans la pile 10. On remarquera que cet axe de la plaque 60 sur lequel est positionné l'axe du transistor 40 n'est pas nécessairement l'axe central de l'espace circulaire 62 du fait, par exemple, des tolérances de fabrication de la plaque 60.

Le driver 48 et le boîtier d'alimentation 50 sont alors montés sur la plaque 60 et les connexions électriques (non représentées) entre le transistor IEGT 40, et ceux-ci sont réalisés, finalisant de ce fait le montage du macro-composant qui est alors retiré du gabarit 100.

Les ensembles vis/boulons 86 maintiennent ainsi le transistor IEGT 40 dans une position de l'espace 62 correspondant à un centrage avec l'axe X-X de la pile 10.

La connexion préalable du transistor 40 avec son driver 48 et son boîtier d'alimentation 50 évite une connexion fastidieuse de ces éléments dans la pile 10. De plus, le fait que le transistor IEGT 40 soit connecté à son boîtier d'alimentation 50 empêche le dépôt d'électricité statique sur les surfaces de celui-ci, ce qui évite d'avoir à utiliser les systèmes de l'état de la technique ayant la même fonction mais généralement difficilement retirables une fois le transistor monté dans la pile.

Ainsi, l'opérateur montant dans la pile 10 le macro-composant formé du transistor 40, de la sucette 46, du driver 48 et du boîtier 50 n'a plus qu'à établir les connexions du driver 48 et du boîtier 50 avec leur environnement, c'est-à-dire une connexion électrique du boîtier 48 avec une source d'alimentation électrique et une connexion par fibres optiques du driver 50 avec un automate de commande de commutation du transistor IEGT 40 pour la réception par le driver 50 de signaux de commande de commutation du transistor 40.

Les emplacements du driver 48 et du boîtier 50 dans la plaque 60 sont choisis pour que leur connexion au transistor IEGT 40 soit courte. Ainsi l'encombrement total du macro-composant est réduit, ce dernier présentant en outre une épaisseur faible qui facilite la manipulation de la pile 10.

De manière avantageuse, le macro-composant sera vendu tel quel. Ainsi, le remplacement d'un transistor défectueux est facilité puisqu'un opérateur de maintenance n'a qu'à déconnecter le driver et le boîtier d'alimentation de celui-ci, puis à connecter le driver et le boîtier du macro-composant nouvellement monté dans la pile en remplacement de l'ancien défectueux.

Pour extraire un semi-conducteur 38, 40 défectueux de la pile 10, les boulons 28 de la pile 10 sont dévissés, relâchant de ce fait la pression exercée sur les ensembles press-pack 12, 14, 16. Le semi conducteur est ainsi extractible en tirant longitudinalement la sucette qui lui est associé, sans démonter l'ensemble de la pile 10 comme cela est le cas des systèmes de centrage utilisant des goupilles de centrage.

## Revendications

1. Dispositif à semi-conducteur destiné à être monté dans un ensemble à empilement pressé (10), comportant :
- un élément à semi-conducteur sous forme de galette (40) ayant un axe longitudinal central;
- une pièce (46) de positionnement de l'élément à semi-conducteur comprenant un espace (62) transversal de réception de celui-ci, des moyens (64, 76, 86) de maintien de l'élément à semi-conducteur dans cet espace (62), et une portion de positionnement (72) de la pièce (46) dans l'ensemble à empilement pressé ; et
- des moyens (86) de positionnement et d'immobilisation transversale de l'élément à semi-conducteur (40) dans l'espace (62) de réception,
**caractérisé en ce que** lesdites moyens de positionnement et d'immobilisation transversale sont réglables.

2. Dispositif selon la revendication 1, **caractérisé en ce que** les moyens réglable (86) de positionnement et d'immobilisation sont aptes à positionner l'axe longitudinal central de l'élément à semi-conducteur sur un axe de la pièce (46) sensiblement confondu avec l'axe d'empilement de l'ensemble à empilement pressé (12, 14, 16) lorsque l'élément à semi-conducteur (40) est monté dans celui-ci.

3. Dispositif selon la revendication 1 ou 2, **caractérisé en ce que** les moyens réglable (86) de positionnement et d'immobilisation comportent des vis de réglage de la position transversale de l'élément à semi-conducteur (40) dans l'espace (62) de ladite pièce (46).

4. Dispositif selon la revendication 1, 2 ou 3, **caractérisé en ce que** les moyens de maintien comprennent des moyens (64, 76) d'immobilisation longitudinale de l'élément à semi-conducteur (40) dans l'espace de réception (62).

5. Dispositif selon la revendication 4, **caractérisé en ce que** les moyens d'immobilisation longitudinale comprennent une bride (74) apte à plaquer une collerette périphérique (78) de l'élément à semi-conducteur (40) sur une surface transversale (64) de la pièce (46) de positionnement.

6. Dispositif selon l'une quelconque des revendications précédentes, **caractérisé en ce que** la pièce de positionnement (46) comporte une poignée (74).

7. Dispositif selon l'une quelconque des revendications précédentes, **caractérisé en ce que** la portion de positionnement de la pièce dans l'ensemble à empilement pressé comprend au moins un arceau (72) aptes à loger un tirant (24) de l'ensemble à empilement pressé (10).

8. Dispositif selon l'une quelconque des revendications précédentes, **caractérisé en ce que** ladite pièce (46) est constituée d'une résine.

9. Ensemble à empilement pressé (10) comportant un ensemble de dispositifs à élément à semi-conducteur pressés selon un axe d'empilement longitudinal (X-X), au moins un de ces dispositifs étant amovible,
**caractérisé en ce que** cet au moins un dispositif amovible est réalisé selon la revendication 1, de manière à centrer l'axe longitudinal central de l'élément à semi-conducteur (40) sur un axe de la pièce (46) sensiblement confondu avec l'axe d'empilement (X-X).

10. Procédé de centrage d'un axe longitudinal central d'un élément à semi-conducteur sous forme de galette (40) sur un axe d'empilement longitudinal (X-X) d'un ensemble à empilement pressé, **caractérisé en ce qu'**il comprend les étapes consistant à :
- mettre en place une pièce (46) pourvue d'un espace de réception (62) de l'élément à semi-conducteur sur un gabarit de centrage (100) muni d'un organe de positionnement de l'axe central de l'élément à semi-conducteur (40) sur un axe prédéterminé du gabarit (100) ;
- positionner l'élément à semi-conducteur (40) dans l'espace de réception (62) de la pièce (46) en positionnant l'axe central de l'élément à semi-conducteur sensiblement sur l'axe prédéterminé du gabarit (100) à l'aide de l'organe de positionnement ;
- solidariser l'élément à semi-conducteur (40) avec la pièce (46) à l'aide de moyens (64, 76, 86) de maintien de l'élément à semi-conducteur dans cet espace (62) et de moyens réglables (86) de positionnement et d'immobilisation transversale ; et
- retirer l'ensemble solidarisé formé de l'élément à semi-conducteur (40) et de la pièce de support (46) du gabarit (100).

11. Procédé selon la revendication 10, **caractérisé en ce qu'**il comporte en outre une étape de montage de l'ensemble solidarisé dans l'ensemble à empilement pressé.
